Europäisches Patentamt

European Patent Office

Office européen des brevets

(11) Publication number: **0 164 794**
**B1**

(12) EUROPEAN PATENT SPECIFICATION

(45) Date of publication of patent specification: 25.07.90

(51) Int. Cl.⁵: **H 01 L 23/36**, H 01 L 23/04

(21) Application number: 85200826.7

(22) Date of filing: 22.05.85

(54) Multi-layer heat sinking integrated circuit package.

(30) Priority: 14.06.84 US 620401

(43) Date of publication of application:
18.12.85 Bulletin 85/51

(45) Publication of the grant of the patent:
25.07.90 Bulletin 90/30

(84) Designated Contracting States:
DE FR GB NL

(56) References cited:
EP-A-0 074 168
EP-A-0 100 817
EP-A-0 101 335
GB-A-2 098 001
US-A-4 195 193
US-A-4 401 767

(73) Proprietor: ADVANCED MICRO DEVICES, INC.
901 Thompson Place P.O. Box 3453
Sunnyvale, CA 94088 (US)

(72) Inventor: Johnson, Frederick Q.
2687 Sacramento Street
San Francisco, California 94115 (US)

(74) Representative: Noz, Franciscus Xaverius, Ir.
et al
Boschdijk 155 P.O. Box 645
NL-5600 AP Eindhoven (NL)

Courier Press, Leamington Spa, England.

## Description

### Background of the invention

#### Field of the invention

The present invention relates to an integrated circuit (IC) package, more particularly to a simplified multi-layer package having heat-sink means to quickly remove heat generated within the package by operation of the integrated circuit.

### Description of the prior art

The prior art material to this invention is typified by U.S. Patent 4,338,621 (Braun) wherein a hermetically sealed IC package is back bonded in a recessed lower conductive ceramic member (with cooling enhanced by fins) and an upper conductive ceramic member mounting input/output pins is sealed thereto. Interior interconnections are connected by wire bonds to the die and through metallized vias to the input/output pins. A metal seal ring is provided between the two ceramic members. Other prior art is noted in the Braun patent. As can be seen, the Braun package is a special custom design involving a large number of manufacturing steps.

From EP—A—0101335 there is further known a heat sinking package for an integrated circuit die, the die having a series of electrical contact pads extending around a periphery of a top surface of the die, the package further comprising:

a thermally conductive base having a top die attach surface including a finite die-attach area to which the die is bonded;

an electrically-insulating preform spacedly surrounding said finite die-attach area and having a bottom surface bonded to said base;

metallic microstrips deposited on said preform and forming spaced multiple fingers each having inner ends spacedly juxtaposed the die contact pads and outer ends extending exterior of said preform;

means for wire bonding various of said die contact pads to said microstrip inner ends;

insulative cover means cooperating with a further preform for covering said die attach surface and die.

### Summary

The package of the present invention as claimed provides a simplified heat-sink package which essentially keeps the exterior configuration of a standard ceramic or plastic dual-in-line (DIP) or castellated package for example, for VLSI or gate array applications. The heat rejection characteristics of the package are vastly improved while employing standard lead-frames and without the addition of customizing features.

This invention provides a semiconductor IC package type which allows the mounting of the die directly to a highly thermally conductive substrate which is exposed to the external ambient. The package design allows for various configurations, such as a dual-in-line package, flat pack, i.e., flat leads extending from the package, quad (displaced bend leads), or the like. Construction allows for the use of conventional technology to provide a lead frame, base, and cap. This includes the use of a metallic (or other highly conductive) base plate corresponding to the base of a ceramic dual-in-line package device. A lead frame similar to that used for flat packs is bonded to the base by means of a glass epoxy preform or pre-preg laminate (normally of electrically insulating material). The IC die is then mounted to the base by thermally conductive means, either epoxy or filed glass die attach paste, and interconnections made between the bond pads of the die and posts of the lead frame by wire bond or other means. A cap of electrically insulating or conductive material is then bonded over the package in a manner not to interfere with the electrical operation of the device. After this operation, the package is sufficiently structurally sound to allow for any required lead forming operations.

The package of the invention provides for excellent dissipation of heat generated by the internal IC in a very simplified manner without changing the standard exterior configuration of a standard DIP enclosure, thus continuing to permit close mounting and standard orientation of DIP packages on circuit boards using standard manufacturing and assembly equipment.

### Brief description of the drawing

Figure 1 is a perspective view of one end of a DIP package of the invention.

Figure 2 is a cross-sectional view across the DIP package taken on the line 2-2 of Figure 1.

Figure 3 is a cross-sectional view of a castellated package of the invention.

Figure 4 is a top plan partial view of the base, preform and lead frame prior to die mounting and connection, taken on the line 4-4 of Figure 2.

### Detailed description

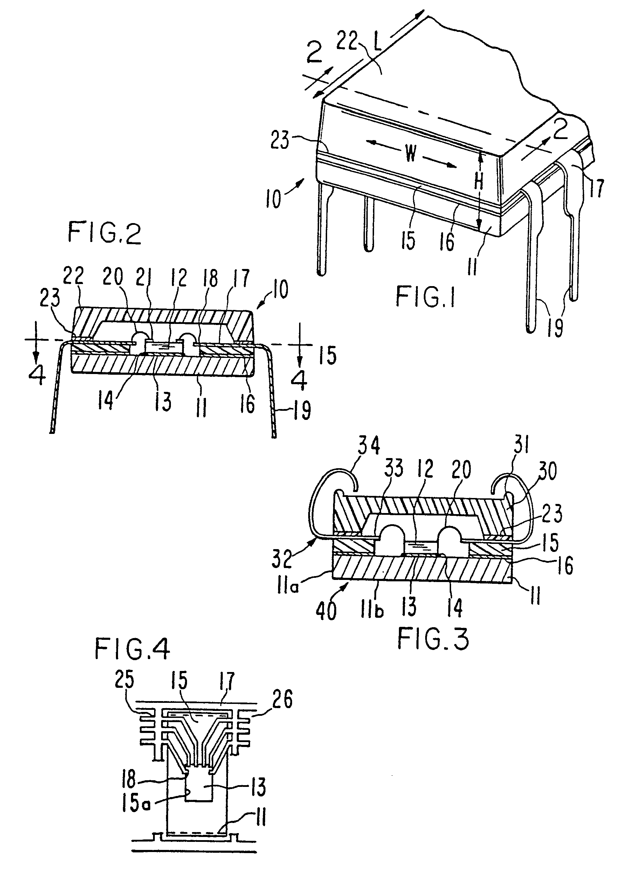

The heat-sink package 10 which confroms in exterior configuration to a standard DIP package but having vastly improved heat rejection capabilities is seen in Figure 1. A rectangular base 11 of thermally conductive material such as copper or aluminum or alloys thereof or beryllia (BeO) having a coefficient of thermal conductivity of at least 1.0467 joules per sec. per cm per °C (0.25 cal/°C s cm), has an exterior dimension substantially the same as a standard DIP package. Standard packages vary in size dependent on the number of input/output terminals in flat contacts extending therefrom for example 16, 20 and 24 terminals. Within each number of terminals the dimensions can slightly vary generally, for example, a 20 terminal package being in the range of 22 mm to 26 mm in horizontal length, 6 mm to 8 mm in width and 6.9 mm to 7.5 mm in height. These are designated by the legends L, W and H in Figure 1. An insulative preform or annular ring 15 of epoxy, glass prepreg such as Ablefilm (trademark of Able Stick Laboratory, Gardena, California) #561K or 550K, or other electrically insulative material is bonded by epoxy resin or other adhesive 16 around the periphery of a finite die-attach area 13 on the top surface of base 11. A lead frame 17 of copper, NILO alloy 42 (42% Ni balance Fe) or other conductive material is placed over and bonded by epoxy glass prepreg to the top of the preform extending over the length and width of the base 11. The lead frame is of conventional construction comprising a series of conductive fingers having inner ends extending inwardly of the inner periphery of the preform and outer ends 19 extending outwardly of the preform and base 11. The fingers are interconnected during manufacture by scored breakaway links 25 (Figure 4) and remain so in initial assembly operations of the package. The bottom of the die containing the integrated circuit is mounted by suitable conductive adhesive such as silver filled epoxy or silver filled glass, to the flat die-attach area of base 11 and the inner fingers bonded by wire bonds to contact pads on the upper surface of the die. After wire bonding the interconnections between the lead frame fingers are physically removed by a stamping or punching operation. An insulative plastic or ceramic cap 22 is bonded by epoxy, polyimide or other insulative adhesive to the top of fingers 17 and to the preform in the space between the fingers. After this operation, the interconnections 25 of the lead frame may be trimmed away and the fingers formed or bent as required.

The attachment of bond wires 20 between contact pads 21 on the periphery of die 12 to the inner ends 18 of lead frame fingers 17 and the positioning of bonding layers 14, 16 and 23 is seen more clearly in Figure 2. Bond wires 20 may be gold, gold alloy or other conventionally used wires of from about 0.635 to 1.016 mm (0.025 to 0.04 inches) in diameter bonded to the die contact pads by conventional means such as thermosonic or thermocompression bonding. The bonding layer 14 is a heat conductive layer of silver or copper-plastic containing a high proportion of conductive particles of silver or copper and having a coefficient of thermal conductivity of at least

$$43.229 \times 10^{-4} \text{ W} \cdot \text{cm}^{-1}.^{\circ}\text{C}^{-1} \text{ (0.25 BTU/fthr}^{\circ}\text{F)}.$$

The preform 15 preferably has a thickness of 0.127 mm (5 mil), i.e., a thickness approximately that of the die 12 so that the top surface of the lead frame extends coplanar with the die contact pads 20.

Figure 3 shows a castellated package 40 in which inner ends 33 of lead frame 32 are wire bonded to contact pads on die 12. Outer ends 34 of the frame are bent upward between castellations 31 integral with the top periphery of cap 30. The aluminum base 11, its sides 11a, and bottom 11b are completely exposed to ambient when assembled on the connector and printed circuit board. The lead fingers from the frame in other embodiments may extend outwardly of the package in the same plane as the interior parts of the frame or may be bent up or down depending on the type of connection or plug-in desired.

Figure 4 shows aluminum base 11 in dotted lines with insulation preform 15 having an aperture 15a exposing the die-attach area 13 of the base 11. The lead frame 17 is placed and bonded to the preform with the ends 18 of the lead frame fingers extending just beyond the preform aperture edges planar to contact pads of the die to be inserted in the preform aperture and bonded to the die-attach portion 13 of base 11.

Thermal measurements were made on a DIP device constructed in accord with Figures 1 and 2 utilizing 24 input/output leads on a copper lead frame. The base was made of an aluminum material available from Alcoa. The cap was constructed of alumina ceramic material, such as available from Narumics Inc.

Dimensions of the aluminum base were

$$14.8 \times 30.5 \times 1.9 \text{ mm}$$

and of the cap

$$13.0 \times 32.0 \times 1.27 \text{ mm}.$$

The die size was 2.10×2.13 mm. The bond wire was aluminum. The die bottom was attached to the aluminum base by a silver-containing epoxy adhesive. The aluminum base extended outwardly from the printed circuit board for maximizing heat rejection.

The molded dual in-line packages were mounted in zero insertion force sockets and placed transverse to the air stream in a wind tunnel. Samples were tested at various air flows and static zero air flow which was theoretically the worst case tested. Thermocouples were mounted directly to the aluminum bottom of the package. The thermal impedance of the device is defined as the rise in junction temperature against a reference point per unit of power dissipation. The temperature of the hottest junction on the die under power dissipation is measured using a substrate diode to monitor chip temperature. The thermal impedance $\theta_{CA}$ (case to ambient) is denoted by the formula:

$$\frac{^{\circ}C_B - ^{\circ}C_A}{P_d}$$

where

$^{\circ}C_B$ is the case base temperature $^{\circ}C$ under power and stablized.

$^{\circ}C_A$ is the ambient temperature and

$P_d$ is the power dissipated by the device which $= I_{cc} \times C_{cc}$, where

$V_{cc}$ is the device voltage supplied by the power supply and

$I_{cc}$ is the supply current.

$\theta_{JA}$, the total thermal resistance from the semiconductor junction to the ambient equals $\theta_{CA} + \theta_{JC}$ where $\theta_{JC}$ (the thermal resistance from the junction to the case) may be considered a constant since its effect on $\theta_{JA}$ is small namely about 3 to 4$^{\circ}$C/watt in devices tested. Four watts of power were furnished to two specimen packages.

A first sample package of a prior art configuration 24 J 600 chosen to be as close to the sample package of the invention as possible in number of leads, type of lead frame, die size, etc. resulted in a measured static air

$$\theta_{JA}=48.8°C/watt.$$

A second package incorporating the invention as described above resulted in a measured static air

$$\theta_{JA}=20.1°C/watt.$$

Therefore for a four watt device in this worse case static air condition the thermal loss to the ambient in the first and second packages were 195.2°C and 80.4°C. respectively. This resulted with a 20°C ambient, the die reaching a temperature of about 215°C in the case of the prior art device and only about 100°C in the device of the invention. This lower die temperature greatly increases the performance and lifetime of the semiconductor device.

As can be seen above, the package of this invention efficiently rejects that generated within a package which utilizes a standard lead frame and standard dimensions of the components (base and cap) used in a standard DIP package. The device may use existing plastic molds, standard trim and form procedures and utilize standard printed circuit board assembly machinery for assembly of the package to the board or other substrate. Likewise, the heat-rejecting DIP packages can be stored, shipped and utilized in assembly operations in and from standard shipping rails.

## Claims

1. A heat-sinking package (10, 40) for an integrated circuit die (12) the die having a series of electrical contact pads (21) extending around a periphery of a top surface of the die (12), the package further comprising:
   a thermally conductive base (11) having a top die-attach surface including a finite die-attach area (13) to which said die (12) is bonded to said finite die-attach area (13) by an electrically-conductive adhesive (14) having a coefficient of thermal conductivity of at least

   $$43.229\times10^{-4}W \cdot cm^{-1} \cdot °C^{-1}\times(0.25 \text{ BTU/ft hr °F});$$

   an electrically-insulating preform (15) spacedly surrounding said finite die-attach area (13) and having a bottom surface bonded to said base (11);
   a metallic lead-frame (17, 32) mounted on said preform (15) and including spaced multiple fingers each having inner ends (18, 33) spacedly juxtaposed to said die contact pads (21) and outer ends (19, 34) extending exterior of said prefrom (15);
   means (20) for wire bonding various of said die contact pads (21) to said lead-frame inner ends (18, 33);
   insulative cover means (22, 30) for covering said top die-attach surface and die (12) having edges bonded to portions of said lead-frame (17, 32) between said lead-frame inner ends (18, 33) and outer ends (19, 34) and to said preform (15) through openings between said spaced lead-frame fingers.

2. The package of claim 1 in which said conductive base (11) comprises a material having a coefficient of thermal conductivity of at least

   $$1.0467 W \cdot cm^{-1} \cdot °C^{-1} (0.25 \text{ cal/°C s cm}).$$

3. The package of claim 2 in which said conductive base (11) comprises copper.

4. The package of claim 2 in which said conductive base (11) comprises aluminum.

5. The package of claim 1 in which said adhesive comprises silver-filled glass epoxy resin.

6. The package of claim 1 wherein said base (11), said preform (15), said lead-frame (17, 32) and said cover means (22) form a dual-in-line package (10).

7. The package of claim 1 wherein said cover means (30) includes castellated peripheral top portions (31) and said outer ends (34) extend between said castellations (31).

8. The package of claim 1 wherein said base (11), said preform (15) and said cover means (22, 30) are peripherally symmetrical in plan view.

9. The package of claim 1 wherein said base (11) has a flat overall surface including said top die-attach surface.

10. The package of claim 1 wherein said preform (15) and said lead-frame (17, 32) have a collective thickness conforming to the height of said die (12) whereby the top of said lead-frame inner ends (18, 33) are in the same horizontal plane as said die contact pads (21).

11. The package of claim 1 wherein said base (11), when assembled on a printed circuit board, has its exterior bottom surface (11b) completely exposed to ambient.

## Patentansprüche

1. Wärmeableitendes Gehäuse (10, 40) für ein Halbleiterplättchen (12) mit integrierter Schaltung, wobei das Halbleiterplättchen eine Reihe elektrischer Kontaktplättchen (21) aufweist, die sich um einen Umfang einer Oberseite des Halbleiterplättchens (12) erstrecken, dadurch gekennzeichnet, dass das Gehäuse ferner umfasst:
   eine thermisch leitende Basis (11) mit einer dielektrischen Oberseite, die eine endliche Befestigungsfläche (13) für das Halbleiterplättchen enthält, mit der das Halbleiterplättchen (12) mittels eines elektrisch leitenden Klebstoffes (14) verbunden ist, der einen Wärmeleitungskoeffizienten von mindesten

   $$43,229\times10^{-4}W . cm^{-1} . °C^{-1} (0,25 \text{ BTU/ft hr °F})$$

   aufweist;
   eine elektrisch isolierende Vorform (15), die in Abstand die endliche Befestigungsfläche (13) für das Halbleiterplättchen umgibt und eine Bodenfläche hat, die mit der Basis (11) verbunden ist;

einen metallischen Anschlussleitungsrahmen (17, 32), der an der Vorform (15) befestigt ist und eine Anzahl in Abstand voneinander liegender Finger aufweist, von denen jeder innere Enden (18, 33) hat, die in Abstand neben den Kontaktplättchen (21) des Halbleiterplättchens liegen, und äussere Enden (19, 34), die sich von der Vorform (15) nach aussen erstrecken;

eine Einrichtung (20) zur Drahtverbindung verschiedener der Kontaktplättchen (21) des Halbleiterplättchens mit den inneren Enden (18, 33) des Anschlussleitungsrahmens;

eine Isolierabdeckung (22, 30) zur Abdeckung der Oberseite der Befestigungsfläche für das Halbleiterplättchen und des Halbleiterplättchens (12), die Ränder hat, die mit den Abschnitten des Anschlussleitungsrahmens (17, 32) zwischen den inneren Enden (18, 33) des Anschlussleitungsrahmens und den äusseren Enden (19, 34) und mit der Vorform (15) über Öffnungen zwischen den in Abstand voneinander liegenden Fingern des Anschlussleitungsrahmens verbunden sind.

2. Gehäuse nach Anspruch 1, dadurch gekennzeichnet, dass die leitende Basis (11) einen Werkstoff umfasst, der einen Wärmeleitungskoeffizienten von mindestens

$$1,0467 \text{ W} \cdot \text{cm}^{-1} \cdot {}^\circ\text{C}^{-1} \text{ (0.25 cal/}{}^\circ\text{C s cm)}$$

umfasst.

3. Gehäuse nach Anspruch 2, dadurch gekennzeichnet, dass die leitende Basis (11) Kupfer umfasst.

4. Gehäuse nach Anspruch 2, dadurch gekennzeichnet, dass die leitende Basis (11) Aluminium umfasst.

5. Gehäuse nach Anspruch 1, dadurch gekennzeichnet, dass der Klebstoff ein Silber enthaltendes Glasepoxidharz umfasst.

6. Gehäuse nach Anspruch 1, dadurch gekennzeichnet, dass die Basis (11), die Vorform (15), der Anschlussleitungsrahmen (17, 32) und die Isolierabdeckung (22) ein Dil-Gehäuse (10) bilden.

7. Gehäuse nach Anspruch 1, dadurch gekennzeichnet, dass die Isolierabdeckung (30) zinnenartige, umfangsseitige Oberseitenabschnitte (31) umfasst und dass sich die äusseren Enden (34) zwischen den Zinnen (31) erstrecken.

8. Gehäuse nach Anspruch 1, dadurch gekennzeichnet, dass die Basis (11) die Vorform (15) und die Isolierabdeckung (22, 30) im Grundriss umfangsseitig symmetrisch sind.

9. Gehäuse nach Anspruch 1, dadurch gekennzeichnet, dass die Basis (11) eine flache Gesamtfläche aufweist, einschliesslich der Oberseite der Befestigungsfläche für das Halbleiterplättchen.

10. Gehäuse nach Anspruch 1, dadurch gekennzeichnet, dass die Vorform (15) und der Anschlussleitungsrahmen (17, 32) eine Gesamtdicke haben, die der Höhe des Halbleiterplättchens (12) entspricht, so dass die Oberseite der inneren Enden (18, 33) des Anschlussleitungsrahmens in der gleichen Horizontalebene wie die Kontaktplättchen (21) liegt.

11. Gehäuse nach Anspruch 1, dadurch gekennzeichnet, dass die Basis (11) nach Montage auf einer gedruckten Schaltungskarte mit ihrer äusseren Bodenfläche (11b) völlig der Umgebungsatmosphäre ausgesetzt ist.

**Revendications**

1. Boîtier formant radiateur (10, 40) destiné à une puce de circuit intégré (12), la puce ayant une série de plages (21) de contacts électriques placées à la périphérie d'une face supérieure de la puce (12), le boîtier comportant en outre:

une base (11) conductrice de la chaleur ayant une surface supérieure de fixation de puce comprenant une zone définie (13) de fixation de puce à laquelle est fixée la puce (12) par un adhésif (14) conducteur de l'électricité, ayant un coefficient de conductibilité thermique d'au moins

$$43,229.10^{-4} \text{ W} \cdot \text{cm}^{-1} \cdot {}^\circ\text{C}^{-1} \text{ (0.25 BTU/ft.hr.}{}^\circ\text{F)},$$

une préforme (15) isolante de l'électricité, entourant ladite zone définie (13) de fixation de puce à distance de celle-ci et ayant une surface inférieure fixée à la base (11),

un cadre métallique (17, 32) à fils de connexion monté sur la préforme (15) et comprenant plusieurs doigts espacés dont les extrémités internes (18, 33) sont juxtaposées aux plages (21) de contacts de la puce et sont placées à distance de celle-ci et des extrémités externes (19, 34) qui dépassent à l'extérieur de la préforme (15),

un dispositif (20) destiné à relier par des fils métalliques diverses plages (21) de contacts de la puce aux extrémités internes (18, 33) du cadre à fils de connexion,

un couvercle isolant (22, 30) destiné à récouvrir la surface supérieure de fixation de puce et la puce (12) et ayant des bords fixés à des parties du cadre (17, 32) à fils de connexion entre les extrémités internes (18, 33) et les extrémité externes (19, 34) du cadre et à la préforme (15) par des ouvertures formées entre les doigts espacés du cadre à fils de connexion.

2. Boîtier selon la revendication 1, dans lequel la base conductrice (11) est formée d'un matériau dont le coefficient de conductibilité thermique est au moins égal à

$$1,0467 \text{ W.cm}^{-1} \cdot {}^\circ\text{C}^{-1} \text{ (0,25 cal/}{}^\circ\text{C.s.cm)}.$$

3. Boîtier selon la revendication 2, dans lequel la base conductrice (11) est formée de cuivre.

4. Boîtier selon la revendication 2, dans lequel la base conductrice (11) est formée d'aluminium.

5. Boîtier selon la revendication 1, dans lequel l'adhésif est une résine époxyde chargée de verre et chargée d'argent.

6. Boîtier selon la revendication 1, dans lequel la base (11), la préforme (15), le cadre (17, 32) de fils de connexion et le couvercle (22) forment un boîtier (10) à deux lignes de connexion.

7. Boîtier selon la revendication 1, dans lequel le couvercle (30) a des parties supérieures périphériques crénelées (31) et les extrémités externes (34) dépassent entre les créneaux (31).

8. Boîtier selon la revendication 1, dans lequel la base (11), la préforme (15) et le couvercle (22, 30) sont symétriques périphériquement en vue en plan.

9. Boîtier selon la revendication 1, dans lequel la base (11) a une surface globale plate comprenant la surface de fixation de puce.

10. Boîtier selon la revendication 1, dans lequel la préforme (15) et le cadre (17, 32) à fils de connexion ont une épaisseur collective correspondant à la hauteur de la puce (12) de manière que la partie supérieure des extrémités internes (18, 33) du cadre se trouve dans le même plan horizontal que les plages de contacts (21) de la puce.

11. Boîtier selon la revendication 1, dans lequel la base (11), lorsqu'elle est montée sur une carte de circuit imprimé, a sa surface inférieure externe (11b) totalement exposée à l'atmosphère ambiante.

FIG.2

FIG.1

FIG.3

FIG.4